# EUROPEAN PATENT SPECIFICATION

(11) **EP 4 420 155 B1**
(45) Date of publication and mention of the grant of the patent: **05.11.2025**
(21) Application number: 22773305.2
(22) Date of filing: 01.09.2022
(51) Int. Cl.: H01L 21/48, H01L 23/373, C09K 5/14

(54) **HEAT SPREADER MATERIAL**
WÄRMEVERTEILMATERIAL
MATÉRIAU DE DISSIPATEUR THERMIQUE

(30) Priority: 19.10.2021 WO PCT/IB2021/059607
(43) Date of publication of application: 28.08.2024
(73) Proprietor: ArcelorMittal, 1160 Luxembourg (LU)
(72) Inventor: BLANCO ROLDAN, Cristina, 33940 El Entrego, Asturias (ES); ALVAREZ-ALVAREZ, Abel, 33009 Oviedo, Asturias (ES); NORIEGA PEREZ, David, 33011 Oviedo, Asturias (ES); RODRIGUEZ GARCIA, Jorge, 33206 Gijón, Asturias (ES); PEREZ RODRIGUEZ, Marcos, 33800 Cangas Del Narcea, Asturias (ES); SUAREZ SANCHEZ, Roberto, 33401 Avilés, Asturias (ES)
(74) Representative: Lavoix
(86) International application number: PCT/IB2022/058224
(87) International publication number: WO 2023/067403

(56) References cited:
- EP-A1- 2 327 542
- CN-A- 106 847 767
- JP-A- 2021 128 953
- JP-A- H11 240 706
- US-A1- 2018 063 996

## Description

This invention relates to a method for manufacturing a graphite laminate, to a graphite laminate and its use in a heat spreader device. Such a heat spreader device can be used, for dissipating the heat and preventing an excessive temperature, in any heat generating components such as integrated circuits of a variety of electronic products, light sources of LEDS or semiconductor devices.

Until early 2000's, heat spreader materials were made of aluminium and aluminium-based alloys. But the demand of lighter and more efficient material led to the development of graphite-based heat spreader material. The graphite can either be natural or synthetic. Natural graphite is mined while synthetic graphite can be produced by graphitizing a carbon-based material. However, the synthetic graphite differs from the natural one in that it can have a higher crystallinity degree and less impurities leading to a greater conductivity.

However, an even greater quantity of heat needed to be dissipated led to thicker graphite-based heat spreader material. Unfortunately, the rule of thumb is that for synthetic graphite, greater is the thickness of the precursor film to be graphitized, lower is the crystalline degree of the final graphitized film and thus lower is its thermal conductivity. This means that, when the thickness of the precursor film is increased, the graphitization of the whole bulk material is less efficient.

Consequently, to increase the heat spread, a common approach has been to laminate two or more graphite-based layers using an adhesive film. However, such graphite laminates lead to the appearance of splices, wrinkles and bubbles leading to yield loss.

JP 2021 128953 A discloses a graphite based heat spreader.

The goal of this invention is to increase the yield of such a graphite laminate. This is achieved by a manufacturing method according to claims 1 to 11. This is also achieved by a graphite laminate according to claim 12 or 13.
Figure 1 is an embodiment of the adhesive deposition step of the claimed process and Figure 2 is an embodiment of two graphite layers coated by an adhesive layer
Figure 3 is an embodiment of the positioning a graphite layer, on an adhesive layer on top of a first stack of layers so as to form a second stack of layers, having a graphite layer as top and bottom layers
Figure 4 is an embodiment of the compressing step of the claimed process.
Figure 5 is an embodiment of the heating step of the claimed process.
Figure 6 is an embodiment of a graphite laminate manufactured by the claimed process.
Figure 7 is a plot exhibiting the influence of the pressure on the thermal conductivity of a graphite laminate material.

The invention also relates to a method for manufacturing a heat spreader comprising the steps of
i. depositing an adhesive 1 on a major surface of at least one graphite layer 2, to obtain at least one graphite layer coated by an adhesive layer, wherein
   a. said adhesive layer 10 has a thickness from 0.5 to 10 µm and comprises a solvent,
   b. said at least one graphite layer 2 has a thickness from 10 to 200 µm and has two opposed major surfaces,
ii. optionally positioning said at least one graphite layers coated by an adhesive layer on top of at least a further graphite layer 2 coated by an adhesive layer 10 so as to form a first stack of layers 3 alternating graphite layers and adhesive layers,
iii. positioning a graphite layer 20 having a thickness from 10 to 200 µm, on said first stack of layers 3 so as to form a second stack of layers 4, having a graphite layer as top and bottom layers
iv. compressing said second stack of layer 4 with a pressure from 7 to 20 MPa to form a graphite-based laminate 5,
v. heating said graphite-based laminate 5 such that the solvent of the adhesive is removed.

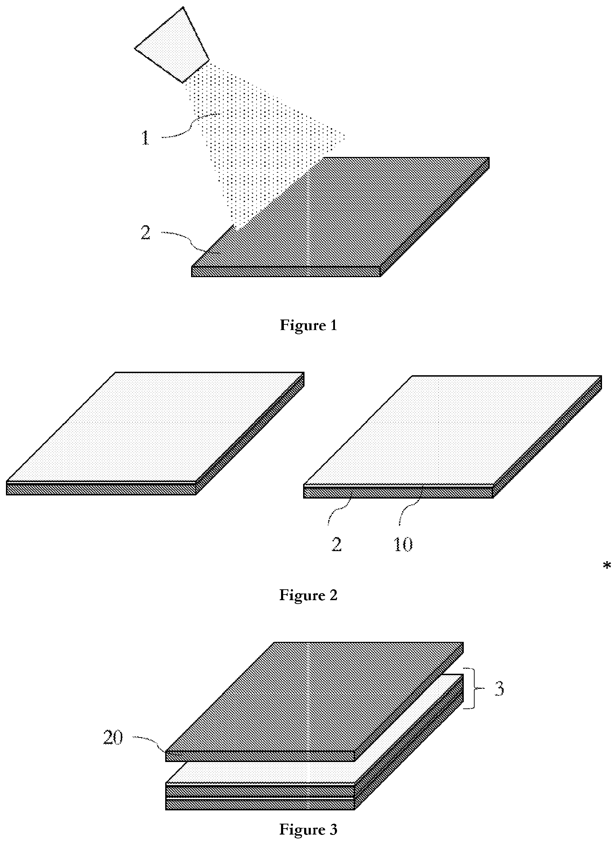

The deposition step, step i., is illustrated in Figure 1 wherein an adhesive 1 is deposited on a major surface of a graphite layer 2 which result, as illustrated in Figure 2, in at least one graphite layer 2 coated by an adhesive layer 10.

Preferably, in step i. the deposition is made by spraying. This can be done using an air spray gun, either fed by gravity or by a pump. The adhesive is then sprayed either manually or via automatic control with the parameters fixed according to the line of production requirements. Preferably, the air pressure is between 0.8 and 2 bar and it is selected according to the aperture of the needle for the adhesive feed.

Preferably, in step i. the deposition is made by rubbing an adhesive. This can be done by using a sponge or cloth soaked in adhesive, moved relatively with respect to the film in a longitudinal way and over its surface.

Alternatively, in step i., the deposition can be made by brushing and/or rolling and/or slot-die coating.

Preferably, in step i. said adhesive layer comprises organofunctional silanes and functionalized nanoscale SiO₂ particles. Even more preferably, in step i., said adhesive is composed of organofunctional silanes and functionalized, nanoscale SiO₂ particles. For example, said adhesive layer is a water-borne sol-gel system composed of organofunctional silanes and functionalized, nanoscale SiO₂ particles. Said adhesive can be mixed with water.

Alternatively, in step i., said adhesive layer can comprise aminofunctional silane being hydrolized before application.

Preferably, in step i., said adhesive layer has a thickness of from 0.5 to 5 µm. Preferably, in step i. said adhesive layer has a thickness from 1 µm to 5 µm
The at least one graphite layer may be any graphite in the form of a sheet or a foil that exhibits anisotropic thermal conductivity.

Preferably, in step i. said at least one graphite layer is made of compressed exfoliated natural graphite, pyrolytic graphite or heat treated graphitizable polymer. Even more preferably, said at least one graphite layer is made from heat treated polyimide. Even more preferably, said at least one graphite layer is made from graphene oxide. Forming processes of such graphite layer are well known by the skilled in the art.

Preferably, in step i. said at least one graphite layer has a thickness from 15 to 200 µm. Such thicker graphite layer increases the mechanical resistance and thus limit the breakage risk during the compressing of step iv.

Preferably, in step i. said at least one graphite layer has an in-plane thermal conductivity of at least 400 W.mK⁻¹, more advantageously of at least 1000 W.mK⁻¹, still more advantageously of at least 1400 W.mK⁻¹.

In another embodiment, in step i., said at least one graphite layer has an in-plane thermal conductivity from 400 to 2500 W.mK⁻¹.

Preferably, in step i. said at least one graphite layer is composed of 1 film. So, each graphite layer is composed of 1 film.

Alternatively, in step i. said at least one graphite layer is composed of 2 to 6 films. So, each graphite layer is composed of 2 to 6 films.

Preferably, in step i. an adhesive layer is deposited on one graphite layer. Preferably, in step i., an adhesive layer is deposited on two to seven graphite layers.

In the case where in step i., an adhesive is deposited on only one graphite layer, the step ii. can be skipped as the coated graphite layer forms the first stack of layers.

In step ii., which is optional, the at least one graphite layer coated by an adhesive layer obtain in step i. is positioned on top of at least a further graphite layer coated by an adhesive layer. For example, the at least one graphite layer obtained by an adhesive layer can be positioned on top of two graphite layers coated by an adhesive layer.

In step iii., as illustrated in Figure 3, a graphite layer 20 is positioned on the first stack of layers 3. The graphite layer is positioned on an adhesive layer to form a stack of layers
- alternating graphite layer and adhesive layer, and
- having a graphite layer as top and bottom layers.

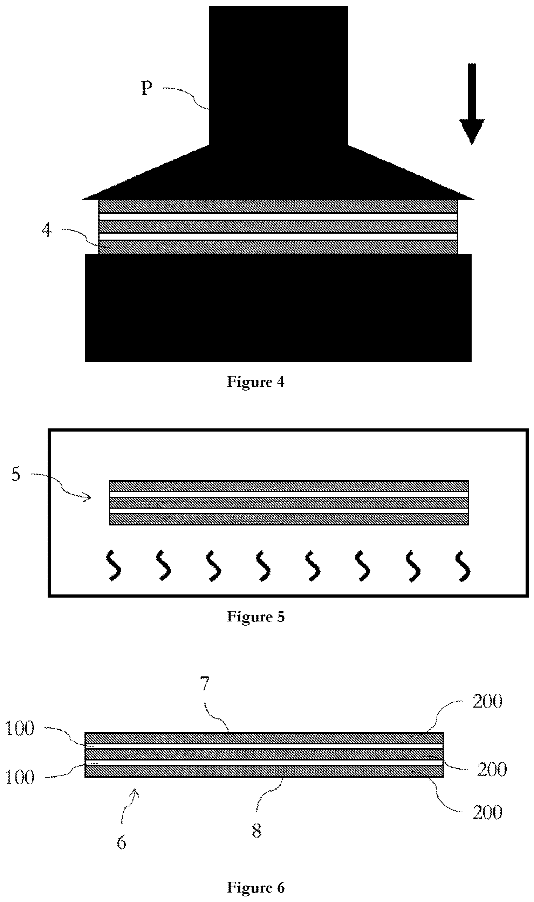

The step iv. is embodied in Figure 4 wherein the second stack of layers 4 is compressed, by a press P.

Preferably, in step iv. said compression is done with a pressure from 10 to 16 MPa.

Preferably, in step iv. said compression is made by means of a press, preferably by means of a hydraulic press.

Preferably, in step iv. said compression is made by means of a roller.

The step v. aiming to remove the solvent is well known by any skilled in the art.

Preferably, in step v. said heating is done at a temperature from 50°C to 150°C.Even more preferably, in step iv. said heating is done at a temperature from 70°C to 130°C.

Preferably, in step v. said heating is done during 20 to 120 minutes. Even more preferably, in step iv. said heating is done during 30 to 60 minutes.

The invention, as illustrated in Figure 6, also relates to a graphite laminate 6, manufactured as previously described, comprising at least two graphite layers 200, having a thickness from 5 to 100 µm, and at least one adhesive layer 100, having a thickness from 1 to 5 µm, wherein
- said at least two graphite layers 200 and said at least one adhesive layer 100 are disposed alternately on top of each other and
- the top layer 7 and the bottom layer 8 of said graphite laminate are graphite layers.

So, said graphite layers 200 and said adhesive layer 100 are disposed alternatively so as to form an alternance of graphite layer and of adhesive layer. This is illustrated in Figure 6 wherein a graphite laminate comprises fives layers, three of graphite and two of adhesive and wherein a graphite layer is on top of an adhesive layer being on top of a graphite layer being on top of an adhesive layer being on top of a graphite layer.

Preferably, said graphite laminate comprises from two to seven graphite layers.

Preferably, said at least two graphite layers are made of compressed exfoliated natural graphite, pyrolytic graphite or heat treated graphitizable polymer.

Preferably, said at least two graphite layers have a thickness from 15 to 100 µm.

Preferably, said at least two graphite layers have an in-plane thermal conductivity from 400 to 2500 W.mK⁻¹.

The thickness of the adhesive layer of the graphite laminate differs from the thickness of the coated adhesive layer in step i. of the process due to the heating step (step v.) where the solvent of the adhesive is removed. Preferably, said at least one adhesive layer 100 has a thickness from 1 to 3 µm.

Preferably, said adhesive layer comprises organofunctional silanes and functionalized nanoscale SiO2 particles. Even more preferentially, said adhesive layer is composed of organofunctional silanes and functionalized nanoscale SiO2 particles.

The invention also relates to the use of said graphite laminate for a heat spreader device. The heat spreader device can be used in electronic device, such as a mobile phone or a motherboard.

### EXPERIMENTAL RESULTS

Experimental trials have been conducted to assess the impact of the value of the net pressure during the step iii. of the claimed process.

For all trials, polyimide films having a thickness from 50 µm were graphitized. To do so, the polyimide films were carbonized by a heat treatment at 1000°C in an inert atmosphere of N2 during 60 minutes to remove all the non-carbon groups of the polymer. Then the carbonized films were put in a graphitization furnace having an Ar inert atmosphere and underwent a heat treatment up to 2800°C in order to rearrange the carbon atoms into the crystal lattice of graphite, thus obtaining graphite films of around 40 µm. After, the graphite films were rolled to reduce the porosity and increase their thermal conductivity. The resulting films have an in-plane thermal conductivity around 900 to 1000 W.mK⁻¹ and a thickness in the order of 25 um.

For all trials, an adhesive layer of around 1 µm was deposited by spray coating on a first face of a graphite film, as illustrated in Figure 1.

Then, the stack of layers was pressed by a hydraulic press forming a compressed stack of layers, as illustrated in Figure 4. Different pressure values were tested, on different stack of layers, to determine the best range.

Then the compressed stack of layers was put into a furnace, at a temperature of 70 °C during 30 minutes to remove the adhesive solvent, as illustrated in Figure 6.

Ultimately, the in-plane thermal conductivity was measured using as the "Thermal Bridge Method" described in Yifeng Fu *et a*l 2020 *2D Mater.* 7 012001.

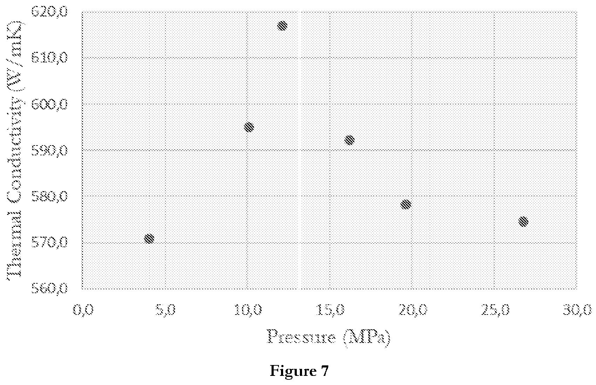

The results of the experiments are plotted in Figure 7 wherein the in-plane thermal conductivity is plotted in function of the pressure applied on the compressed stack of layers.

It is clear that the value of the pressure has an impact on the in-plane conductivity of the graphite laminate and that the best range is for a pressure value from 7 to 20 MPa.

## Claims

1. Method for manufacturing a heat spreader comprising the steps of
i. depositing an adhesive (1) on a major surface of at least one graphite layer (2), to obtain at least one graphite layer (2) coated by an adhesive layer (10) wherein
a. said adhesive layer (10) has a thickness from 0.5 to 10 µm and comprises a solvent,
b. said at least one graphite layer (2) has a thickness from 10 to 200 µm and has two opposed major surfaces,
ii. optionally positioning said at least one graphite layer coated by an adhesive layer on top of at least a further graphite layer (2) coated by an adhesive layer (10) so as to form a first stack of layers (3) alternating graphite layers and adhesive layers,
iii. positioning a graphite layer (20) having a thickness from 10 to 200 µm, on said first stack of layers (3) so as to form a second stack of layers (4), having a graphite layer as top and bottom layers
iv. compressing said second stack of layer (4) with a pressure from 7 to 20 MPa to form a graphite-based laminate (5),
v. heating said graphite-based laminate (5) such that the solvent of the adhesive is removed.

2. Method according to claim 1 wherein, in step i. the deposition is made by spraying an adhesive.

3. Method according to claim 1 wherein, in step i. the deposition is made by rubbing an adhesive.

4. Method according to any one of claims 1 to 3 wherein, in step i. said adhesive layer comprises organofunctional silanes and functionalized nanoscale SiO2 particles.

5. Method according to any one of claims 1 to 4 wherein, in step i. said adhesive layer has a thickness from 1 to 5 µm.

6. Method according to any one of claims 1 to 5 wherein, in step i. said at least one graphite layer (2) is made of compressed exfoliated natural graphite, pyrolytic graphite or heat treated graphitizable polymer.

7. Method according to any one of claims 1 to 6 wherein, in step i. said at least one graphite layer (2) has a thickness from 15 to 200 µm.

8. Method according to any one of claims 1 to 7 wherein, in step i. said at least one graphite layer (2) has an in-plane thermal conductivity from 400 to 2500 W.mK⁻¹.

9. Method according to any one of claims 1 to 8 wherein, in step iii. said compression is made by means of a roller.

10. Method according to any one of claims 1 to 9 wherein, in step iii. said compression is made by means of a press, preferably by means of a hydraulic press.

11. Method according to any one of claims 1 to 10 wherein, in step iii. said compression is done with a pressure from 10 to 16 MPa.

12. A graphite laminate 6, manufactured according to any one of the claims 1 to 11, comprising at least two graphite layers 200, having a thickness from 5 to 100 µm, and at least one adhesive layer 100, having a thickness from 1 to 5 µm, wherein
- said at least two graphite layers (200) and said at least one adhesive layer (100) are disposed alternately on top of each other and
- the top layer (7) and the bottom layer (8) of said graphite laminate are graphite layers.

13. A graphite laminate according to claim 12, wherein said graphite laminate (6) comprises from two to seven graphite layers.

14. The use of a graphite laminate according to claim 12 or 13 in a heat spreader device.

## Patentansprüche

1. Verfahren zum Herstellen eines Wärmeverteilers, umfassend die Schritte eines
i. Aufbringens eines Klebstoffs (1) auf eine Hauptoberfläche mindestens einer Graphitschicht (2), um mindestens eine Graphitschicht (2) zu erlangen, die mit einer Klebstoffschicht (10) überzogen ist,
wobei
a. die Klebstoffschicht (10) eine Stärke von 0,5 bis 10 µm aufweist und ein Lösungsmittel umfasst,
b. die mindestens eine Graphitschicht (2) eine Stärke von 10 bis 200 µm aufweist und zwei gegenüberliegende Hauptflächen aufweist,
ii. optional Positionieren der mindestens einen Graphitschicht, die mit einer Klebstoffschicht darauf beschichtet ist, auf mindestens einer weiteren Graphitschicht (2), die mit einer Klebstoffschicht (10) beschichtet ist, um einen ersten Stapel von Schichten (3) zu bilden, die abwechselnd aus Graphit- und Klebstoffschichten bestehen,
iii. Positionieren einer Graphitschicht (20),
die eine Stärke von 10 bis 200 µm aufweist, auf dem ersten Stapel von Schichten (3), um einen zweiten Stapel von Schichten (4) zu bilden, der eine Graphitschicht als Oberseite und untere Schichten umfasst,
iv. die den zweiten Stapel der Schicht (4) mit einem Druck von 7 bis 20 MPa komprimieren, um Laminat auf Graphitbasis (5) zu bilden, aufweist,
v. Erhitzen des Laminats auf Graphitbasis (5),
sodass das Lösungsmittel des Klebstoffs entfernt wird.

2. Verfahren nach Anspruch 1, wobei in Schritt i. das Aufbringen durch Sprühen eines Klebstoffs erfolgt.

3. Verfahren nach Anspruch 1, wobei in Schritt i. das Aufbringen durch Reiben eines Klebstoffs erfolgt.

4. Verfahren nach einem der Ansprüche 1 bis 3, wobei in Schritt i. die Klebeschicht organofunktionelle Silane und funktionalisierte nanoskalige SiO2-Partikel umfasst.

5. Verfahren nach einem der Ansprüche 1 bis 4, wobei in Schritt i. die Klebstoffschicht eine Stärke von 1 bis 5 µm aufweist.

6. Verfahren nach einem der Ansprüche 1 bis 5, wobei in Schritt i. die mindestens eine Graphitschicht (2) aus gepresstem exfoliertem Naturgraphit, pyrolytischem Graphit oder wärmebehandeltem graphitisierbarem Polymer gefertigt ist.

7. Verfahren nach einem der Ansprüche 1 bis 6, wobei in Schritt i. die mindestens eine Graphitschicht (2) eine Stärke von 15 bis 200 µm aufweist.

8. Verfahren nach einem der Ansprüche 1 bis 7, wobei in Schritt i. die mindestens eine Graphitschicht (2) eine Wärmeleitfähigkeit in der Ebene von 400 bis 2500 W.mK⁻¹ aufweist.

9. Verfahren nach einem der Ansprüche 1 bis 8, wobei in Schritt iii. die Verdichtung mittels einer Walze erfolgt.

10. Verfahren nach einem der Ansprüche 1 bis 9, wobei in Schritt iii. die Verdichtung mittels einer Presse, vorzugsweise mittels einer hydraulischen Presse, erfolgt.

11. Verfahren nach einem der Ansprüche 1 bis 10, wobei in Schritt iii. die Kompression mit einem Druck von 10 bis 16 MPa erfolgt.

12. Graphitlaminat 6, hergestellt nach einem der Ansprüche 1 bis 11, umfassend mindestens zwei Graphitschichten 200 mit einer Stärke von 5 bis 100 µm und mindestens eine Klebstoffschicht 100 mit einer Stärke von 1 bis 5 µm, wobei
- die mindestens zwei Graphitschichten (200) und die mindestens eine Klebstoffschicht (100) abwechselnd aufeinander aufgebracht werden und
- die obere Schicht (7) und die untere Schicht (8) des Graphitlaminats Graphitschichten sind.

13. Graphitlaminat nach Anspruch 12, wobei das Graphitlaminat (6) von zwei bis sieben Graphitschichten umfasst.

14. Verwendung eines Graphitlaminats nach Anspruch 12 oder 13 bei eine Wärmeverteilungsvorrichtung.

## Revendications

1. Procédé de fabrication d'un dissipateur thermique comprenant les étapes de
i. dépôt d'un adhésif (1) sur une surface principale d'au moins une couche de graphite (2), pour obtenir au moins au moins une couche de graphite (2) revêtue d'une couche adhésive (10)
dans lequel
a. ladite couche adhésive (10) a une épaisseur de 0,5 à 10 µm et comprend un solvant,
b. ladite au moins une couche de graphite (2) a une épaisseur de 10 à 200 µm et comporte deux surfaces principales opposées,
ii. positionnement facultatif de ladite au moins une couche de graphite revêtue d'une couche adhésive sur au moins une autre couche de graphite (2) revêtue d'une couche adhésive (10) de manière à former un premier empilement de couches (3) alternant des couches de graphite et des couches adhésives,
iii. positionnement d'une couche de graphite (20) ayant une épaisseur de 10 à 200 µm, sur ledit premier empilement de couches (3) de manière à former un second empilement de couches (4), ayant une couche de graphite en tant que couche supérieure et couche inférieure
iv. comprimant ledit second empilement de couches (4) avec une pression de 7 à 20 MPa pour former un stratifié à base de graphite (5),
v. chauffage dudit stratifié à base de graphite (5) de sorte que le solvant de l'adhésif est éliminé.

2. Procédé selon la revendication 1 dans lequel, à l'étape i., le dépôt est effectué par pulvérisation d'un adhésif.

3. Procédé selon la revendication 1 dans lequel, à l'étape i., le dépôt est effectué par frottement d'un adhésif.

4. Procédé selon l'une quelconque des revendications 1 à 3 dans lequel, à l'étape i., ladite couche adhésive comprend des silanes organofonctionnels et des particules de SiO2 nanométriques fonctionnalisées.

5. Procédé selon l'une quelconque des revendications 1 à 4 dans lequel, à l'étape i., ladite couche adhésive a une épaisseur de 1 à 5 µm.

6. Procédé selon l'une quelconque des revendications 1 à 5 dans lequel, à l'étape i., ladite au moins une couche de graphite (2) est constituée de graphite naturel exfolié comprimé, de graphite pyrolytique ou de polymère graphitisable traité thermiquement.

7. Procédé selon l'une quelconque des revendications 1 à 6 dans lequel, à l'étape i., ladite au moins une couche de graphite (2) a une épaisseur de 15 à 200 µm.

8. Procédé selon l'une quelconque des revendications 1 à 7 dans lequel, à l'étape i., ladite au moins une couche de graphite (2) a une conductivité thermique dans le plan de 400 à 2500 W.mK⁻¹.

9. Procédé selon l'une quelconque des revendications 1 à 8 dans lequel, à l'étape iii., ladite compression est effectuée au moyen d'un rouleau.

10. Procédé selon l'une quelconque des revendications 1 à 9 dans lequel, à l'étape iii., la compression est effectuée au moyen d'une presse, de préférence au moyen d'une presse hydraulique.

11. Procédé selon l'une quelconque des revendications 1 à 10 dans lequel, à l'étape iii., ladite compression est effectuée avec une pression de 10 à 16 MPa.

12. Stratifié de graphite 6, fabriqué selon l'une quelconque des revendications 1 à 11, comprenant au moins deux couches de graphite 200, d'une épaisseur de 5 à 100 µm, et au moins une couche adhésive 100, d'une épaisseur de 1 à 5 µm, dans lequel
- lesdites au moins deux couches de graphite (200) et ladite au moins une couche adhésive (100) sont disposées alternativement l'une sur l'autre et
- la couche supérieure (7) et la couche inférieure (8) dudit stratifié de graphite sont des couches de graphite.

13. Stratifié de graphite selon la revendication 12, dans lequel ledit stratifié de graphite (6) comprend de deux à sept couches de graphite.

14. Utilisation d'un stratifié de graphite selon la revendication 12 ou 13 dans un dispositif de dissipateur thermique.
